Europäisches Patentamt

European Patent Office

Office européen des brevets

(11) Publication number: 0 480 271 A1

# EUROPEAN PATENT APPLICATION

(21) Application number: 91116619.7

(22) Date of filing: 30.09.91

(51) Int. Cl.⁵: H01L 23/498

(30) Priority: 12.10.90 US 597952

(43) Date of publication of application:
15.04.92 Bulletin 92/16

(84) Designated Contracting States:
DE FR GB

(71) Applicant: MOTOROLA, INC.
1303 East Algonquin Road
Schaumburg, IL 60196(US)

(72) Inventor: Kiffe, Dennis O.
8652 Ephraim Road
Austin, Texas 78717(US)
Inventor: Fetty, Allan M.
13201 Easley Drive
Manchaca, Texas 78652(US)
Inventor: Davis, Dwight W.
11215 Della Torre Drive
Austin, Texas 78750(US)

(74) Representative: Lupton, Frederick et al
Motorola European Intellectual Property
Operations Seal House Seal Road
Basingstoke, Hants RG21 1NO(GB)

(54) Semiconductor device having structures for accurate bonding.

(57) A semiconductor device has bond placement locators for more accurate bonding of bonding wires to large leads, such as POWER and GROUND leads. In one form, a device (55) has a multiple tier package (56) with at least one tier having a plurality of leads (61). A semiconductor die (70) is positioned in a cavity (71) of the package and is electrically coupled, by bonding wires (69), to the plurality of leads. At least one lead of the plurality of leads is configured into two areas. A first area (64) is used for receiving a bond and used by wire bonding equipment to accurately locate bond placement. The first area is located proximate to the cavity and is adjacent a second area. The second area (66) is separated from the cavity by the first area and has substantially more conductive area than the first area.

FIG.4

Technical Field of the Invention

The present invention relates to semiconductor devices in general and more specifically to semiconductor devices having a multiple tier package.

Background of the Invention

A continuing trend in the semiconductor industry is to increase the integration level and circuit density of integrated circuits (ICs) in order to minimize the size of semiconductor devices. For this reason, packages which protect highly integrated ICs have become more and more complex. To accommodate the higher integration levels, various packages have been developed, including multiple tier packages. Multiple tier packages are preformed packages having more than one tier of conductive leads, each tier being at a different level or height within the package. A well known example of a multiple tier package is a PGA (pin grid array) package having an upper and a lower bonding tier. Typically, the upper tier has a plurality of leads designated to be coupled to a specific set of bonding pads of a semiconductor die, while the lower tier is designated to be coupled to a different set of pads on the die. For instance, the leads on the lower tier may be coupled to POWER and/or GROUND bonding pads and the leads on the upper tier may be coupled to bond pads associated with other die functions, such as controlling address and data busses, operating a clock, or the like.

Although multiple tier packages have become widely accepted for packaging highly integrated ICs, these packages have also brought about new manufacturing problems. One problem is that of crossed bonding wires. Bonding wires are very thin conductive wires which are used to couple a lead to a bonding pad. Because there is more than one tier of leads in multiple tier packages, wires bonded to an upper tier must be directed over wires bonded to a lower tier. Occasionally, these wires may cross one another, or touch, thereby creating the possibility of electrically short-circuiting the respective leads and bonding pads. The frequency of this occurrence typically varies from package to package, depending on such factors as the lead density of a package, semiconductor die misalignment in a package, the position of leads of one tier with respect to leads of another tier, and the position of a bonding wire on a lead, to name a few.

Another problem with multiple tier packages is that the wire bonding operation takes a considerable amount of time. Besides the fact that a multiple tier package often has more leads than a single tier package, thereby requiring more time to bond all of the leads, multiple tier packages also require more machine set-up time. Many wire bonding machines are equipped with video locating capabilities wherein the machine can be taught at what positions a bond is to be made given a set of reference points. With each new package design and with each new bond pad configuration, the machine must be taught and programmed where to place the bonds, what shape the bonds are to be, and other bonding parameters. Programs can then be stored and recalled, thereby allowing the machine to automatically bond a wide variety of package types and bond pad configurations.

While single tier packages can be wire bonded quite easily and with little operator assistance using such automated wire bonding equipment, bonding multiple tier packages is more complex. As mentioned previously, multiple tier packages are susceptible to crossed wires. To prevent crossed wires, considerably more time must be spent setting up and teaching the wire bonding equipment. Besides increasing the initial set up time, bonding multiple tier packages also requires more sustaining work. This is true especially of multiple tier packages having special POWER and GROUND leads. On many packages, POWER and GROUND leads are designed differently than other leads. Desirable characteristics of POWER and GROUND leads include low resistivity, low inductance, and high capacitance capabilities. Other leads typically require high resistance and low capacitance. To meet this criteria, POWER and GROUND leads are often made substantially larger than other leads in order to maximize the conductive area of the POWER and GROUND leads. Automated wire bonding equipment has problems in locating the exact position to place a bond on a large lead. On light intensity from the package. Typically the lead material is very reflective, while the actual package material is less reflective. With smaller leads, equipment can actually locate a lead by monitoring reflected light. Once a lead is located, the equipment is instructed to place a bond at a specific position on that lead, for instance in the center. With larger or wider leads, such as some POWER and GROUND leads, a substantial portion of a lead may be out of the equipment's field of view, such that the vision system of the wire bonding equipment views only the material of a lead. In this case, there is no contrast in reflected light; therefore, the equipment cannot determine where the center of the lead is, or where a bond is to be placed. The wire bonding equipment must then rely on an established set of reference points, such as a corner of the package or the corner of the semiconductor die, to place a bond at a specific position relative to the reference points. Using such reference points can be quite inaccurate if the semiconductor die is misaligned or if the leads on the package have been misaligned during package fabrication.

## Brief Summary of the Invention

The aforementioned disadvantages are overcome with the present invention. In one form, a semiconductor device has bond placement locators for more accurate bonding of bonding wires to leads. The device has a semiconductor die, having a plurality of bonding pads located thereon, positioned in a cavity of a multiple tier package. At least one tier of the package has a plurality of leads in which each lead is electrically coupled to a predetermined bonding pad on the semiconductor die. At least one lead on the at least one tier has a first and second area. The first area of the lead, located proximate to the cavity, is used for locating bond placement and for receiving a bonding wire. The second area of the lead is separated from the cavity by the first area and has substantially more conductive area than the first area.

## Brief Description of the Figures

FIG. 1 is a top perspective view of a known semiconductor device having a multiple tier package.

FIG. 2 is a top perspective view of a portion of two bonding tiers of a known semiconductor package, each tier having a plurality of leads.

FIG. 3 is a top perspective view of a portion of two tiers of a semiconductor package in accordance with the present invention, each tier having a plurality of leads.

FIG. 4 is a top perspective view of a semiconductor device having a multiple tier package, also in accordance with the present invention.

## Detailed Description of a Preferred Embodiment

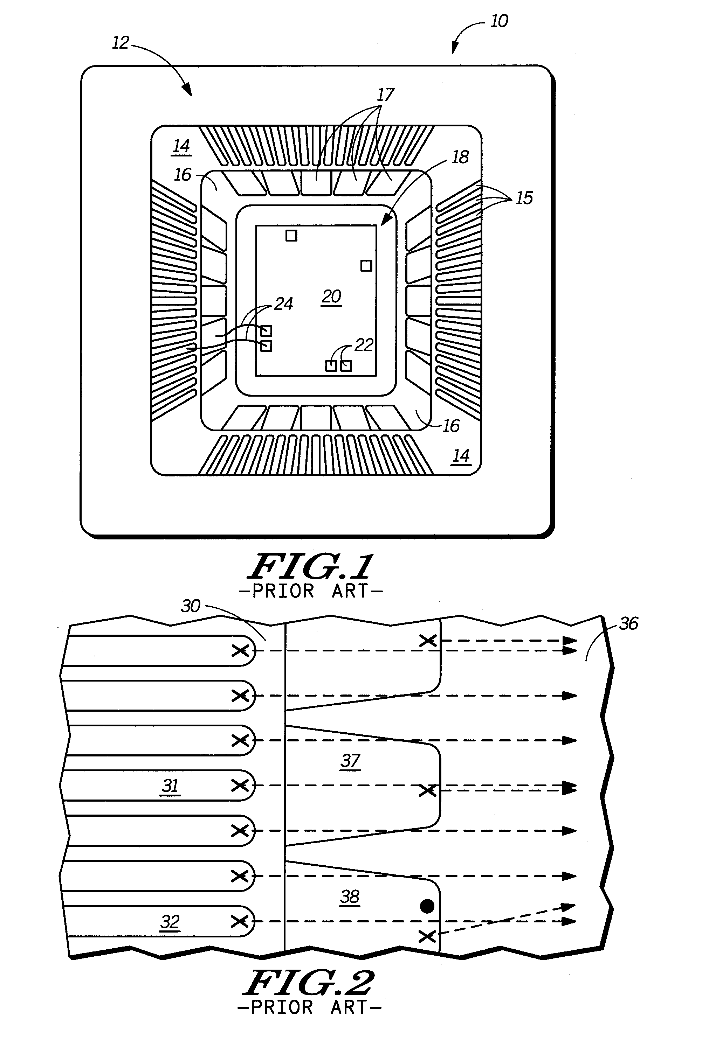

FIG. 1 illustrates a semiconductor device 10 having a multiple tier package 12 which is well known in the semiconductor industry. Package 12 has a first tier 14 located above a second tier 16; however, multiple tier package 12 is not limited to having two bonding tiers. Examples of multiple tier packages which may be used in accordance with the present invention include packages of ceramic, plastic, or flexible substrate materials such as those used to fabricate printed circuit boards. First tier 14 of package 12 has a first plurality of leads 15 and second tier 16 has a second plurality of leads 17. Both pluralities of leads are made of a conductive material such as gold, aluminum, copper, or alloys of these materials. First and second pluralities of leads, 15 and 17 respectively, are electrically coupled to bonding pads, such as bonding pads 22, of a semiconductor die 20. Semiconductor die 20 may be any integrated circuit (IC), such as a microprocessor, an analog device, a memory unit, or the like. The number and position of bonding pads 22 on semiconductor die 20 is typically dependent on the design and functionality of the die used. As illustrated, bonding wires, such as wires 24, are used to electrically couple the leads to the bonding pads. For convenience of illustration, bonding wires are not shown coupled to all bonding pads. The bonding wires may be gold, copper, aluminum, alloys of these materials, or other wire materials commonly used in semiconductor manufacturing.

As illustrated in FIG. 1, first plurality of leads 15 on first tier 14 are shaped differently than second plurality of leads 17 on second tier 16. This is due to the fact that in this illustrative embodiment, second plurality of leads 17 has different electrical requirements than first plurality of leads 15. Second leads 17 have a larger conductive area than first leads 15, and therefore have lower resistance, lower inductance, and higher capacitance capabilities. As discussed previously, such characteristics are desirable in POWER and GROUND signals. Thus, second plurality of leads 17 could be electrically coupled to POWER and GROUND bond pads of semiconductor die 20 in order to optimize the performance of device 10. First plurality of leads 15 could be electrically coupled to bond pads for signals other than POWER and GROUND which operate with higher resistances and lower capacitances.

A closer view of two tiers of a known semiconductor package used in a semiconductor device is illustrated in FIG. 2. This figure is a partial illustration and does not illustrate an entire package or semiconductor device. A first tier 30 has a first plurality of leads, such as 31 and 32. A second tier 36 has a second plurality of leads such as 37 and 38. The particular shape of the leads may vary, for example the edges of leads need not be parallel as illustrated by leads 31 and 32, nor do the tips of these leads need to be rounded. Likewise leads, such as 37 and 38, in the second plurality of leads need not be in the dimensional proportion to the first plurality of leads as illustrated. Suitable shapes for the pluralities of leads include, but are not limited to, trapezoidal shapes and leads in the shape of a parallelogram. The "**X**"s in FIG. 2 represent the placement of bonds or bonding wires on the leads. It is common, although not essential, to place a bond such that the bond is centered between two edges of the leads, as shown. The dashed lines represent bonding wires and the arrows represent the direction in which the wire extend, before reaching a semiconductor die (not shown).

The illustration in FIG. 2 depicts some undesirable bonding characteristics which might occur upon bonding a semiconductor device having a multiple tier package. For example, the bonding wires which extend from leads 31 and 37 are very close to one another, thereby introducing a high probability that the two wires may become crossed, or electrically short circuited to one another. While the bond placement on lead 37 could be adjusted to another portion of lead 37, it is difficult to instruct the wire bonding equipment to place a bond at a precise location on the lead due to its large area. As mentioned earlier, many vision systems find a specific location by measuring a light intensity differential in the equipment's field of view. On large leads such as leads 37 and 38, there may not be any light intensity differential in the field of view. The equipment then relies upon a previously specified reference point, such as a corner of the package or a corner of the semiconductor die and places a bond relative to the specified reference points. With various misalignments which might occur during the manufacturing process, the precise placement of a bond on large leads, such as leads 37 and 38, cannot be guaranteed. Therefore, wire bonding equipment must be programmed to function within a large operating window in order to avoid potential reliability problems. In doing so, more problems can arise, such as bonding wires which are too close to one another or bonding wires which cross. Crossed bonding wires are also illustrated in FIG. 2. As illustrated, a bonding wire which extends from lead 38 crosses a wire which extends from lead 32. The dot ("●") in FIG. 2 represents where the bond should have been placed; however, for some reason the bond was misplaced. Bond misplacement may be caused by the lack of precision in wire bonding equipment during the bonding of large areas mentioned above. Another possibility is that the machine was taught an incorrect position relative to a set of reference points.

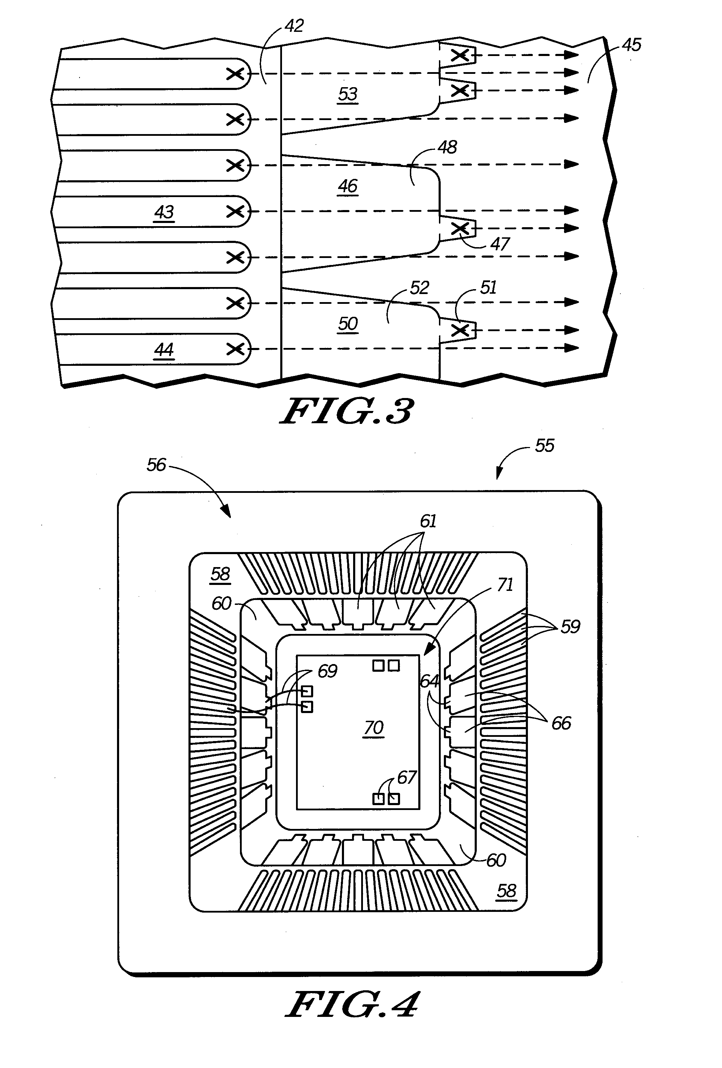

The present invention resolves the aforementioned alignment and bond placement problems and reduces the set-up time necessary to program wire bonding equipment. In one form, a feature is added to existing leads in order to aid in the location of leads and to accurately determine the placement of a bonding wire. Illustrated in FIG. 3 are leads in accordance with the present invention. As in FIG. 2, only a partial view of a semiconductor device is shown. Likewise, the "X"s represent placement of bonds and the dashed lines represent bonding wires. In accordance with the present invention, a first tier 42, of a multiple tier package (not entirely shown), has a first plurality of leads, such as leads 43 and 44. A second tier 45 has a second plurality of leads, such as leads 46, 50, and 53. Also as in FIG. 2, the second plurality of leads has a larger conductive area than the first plurality of leads. Many semiconductor manufacturers employ such a design in order to maximize the electrical performance of semiconductor devices, for instance by using leads with a larger conductive area for transmitting POWER and GROUND signals. The second plurality of leads illustrated in FIG. 3 has been adapted to aid in the placement of bonding wires. For example, lead 46 has two portions, a first area 47 and a second area 48, distinguished from one another by a dashed line. First area 47 of lead 46 is a bond placement locator. This locator is a protrusion or tab which extends from second area 48. First area 47 is preferably of the same material as second area 48; however, first area 47 has substantially less electrically conductive area than second area 48. A suitable conductive area size for first area 47 is less than one-half the conductive area of second area 48. More than one bond placement locator may be formed as part of a lead, depending on the number of bonding wires to be coupled to that particular lead, as illustrated by lead 53.

By including a bond placement locator as part of a lead, such as first area 47 of lead 46, wire bonding equipment can more easily locate the lead and place a bond on first area 47 accurately. Due to the smaller area of first area 47, an equipment's field of view can encompass all of first area 47 and thereby can detect a light intensity differential between light reflected from first area 47 and light reflected from second tier 45. Since first area 47 can be properly located, a wire can be accurately bonded to the first area. An additional advantage achieved by the present invention is that the position of first area 47 with respect to adjacent second area 48 can vary, thus allowing a bond placement to be arranged such that crossed wires are avoided. For example, first area 47 is located in a different position with respect to second area 48 than first area 51 is located with respect to second area 52. Having the flexibility to locate a first area in various positions with respect to a second area permits a package to accommodate most semiconductor die designs. Restrictions for placement of bond pads on a semiconductor die are eased due to the flexibility of bond location to a lead achieved with the present invention. Furthermore, the flexibility in the position of first area 47 significantly reduces the probability of crossed bond wires.

A semiconductor device in accordance with the present invention is illustrated in a top perspective view in FIG. 4. A semiconductor device 55 has a multiple tier package 56. A first tier 58 of package 56 has a first plurality of leads 59. A second tier 60, located below first tier 58, has a second plurality of leads 61. Both pluralities of leads are electrically coupled to one of a plurality of bond pads, such as bond pads 67 located on a semiconductor die 70, according to a predetermined bonding sequence. As illustrated, bond wires 69 are used to make the electrical connection from the leads to the die. The number of leads, bond pads, and bonding wires illustrated are representative and in no way indicate a preferred, suggested, or required quantity. Likewise, the leads as illustrated are positioned radially, toward a point near the center of a die cavity 71. While the leads need not be positioned in this manner, this design is common among many semiconductor manufacturers. In accordance with the present invention, at least one lead of second plurality of leads 61 has a first area 64 and a second area 66. While each of the plurality of second leads 61 are illustrated as having a first and a second area, it may not be necessary for each lead in a plurality of leads to have two such areas. First area 64 is adjacent second area 66 and is proximal to die cavity 71. First area 64 has substantially less conductive area than second area 66 in order for wire bonding equipment to accurately locate first area 64. Upon locating first area 64, the equipment forms a bond of first area 64, thereby providing accurate and repeatable placement of a bond on a large lead.

The present invention overcomes manufacturing difficulties which exist in the assembly of semiconductor devices. More specifically the invention improves the assembly of devices having multiple tier packages by improving the accuracy and repeatability of bond placement during the wire bonding operation. With the invention, leads such as those used for POWER and GROUND signals which have large conductive areas to enhance device performance, can be bonded on a precise location which can be located visually by wire bonding equipment. The invention significantly reduces the probability of having crossed bond wires in a semiconductor device and reduces the amount of time spent on correcting misaligned bonds. In addition, the invention reduces the amount of time spent on initially teaching and programming wire bonding equipment.

Thus it is apparent that there has been provided, in accordance with the invention, a semiconductor device having bond placement locators and a method for positioning bonds in a semiconductor device that fully meets the advantages set forth previously. Although the invention has been described and illustrated with reference to specific embodiments thereof, it is not intended that the invention be limited to these illustrative embodiments. Those skilled in the art will recognize that modifications and variations can be made without departing from the spirit of the invention. For example, use of the invention is not limited to use in packages having two bonding tiers, but may be used with any semiconductor package having multiple tiers. Nor is the invention limited to using the number or shape of the leads illustrated or described. For instance, leads may be of any shape, including substantially rectangular, trapezoidal, or in the shape of a parallelogram. Furthermore, the invention is not limited to using one bond locator with each lead. Rather, any number of bond locators may be designated to an individual lead. Likewise, it is possible to couple more than one lead to a single bonding pad or couple more than one bonding pad to a single lead. In addition, it is not intended that the invention be limited to the use with only one semiconductor die. The use of multiple die in a single package cavity and multiple die in multiple cavities within a single package are also in accordance with the invention. Therefore, it is intended that this invention encompass all such variations and modifications as fall within the scope of the appended claims.

## Claims

1. A semiconductor device (55) having structures for accurate bonding of bonding wires to leads in the semiconductor device, comprising:

   a semiconductor die (70) having first, second, and third bonding pads (67) positioned successively along a first side of the semiconductor die;

   a multi-tier package body (56) comprising:

   a cavity (71) which contains the semiconductor die;

   a first tier (60) surrounding the cavity having a first lead (61) formed thereon, the first lead being adjacent the first side of the semiconductor die and having a protrusion (64) formed on an end which is nearest the cavity; and

   a second tier (58) surrounding the cavity, located above the first tier, and having second and third leads (59) formed thereon, the second and third leads being positioned successively and adjacent the first side of the semiconductor die;

   a first bonding wire (69) electrically coupling the second lead to the first bonding pad;

   a second bonding wire (69) electrically coupling the third lead to the third bonding pad; and

   a third bonding wire (69) electrically coupling the protrusion formed on the first lead to the second bonding pad such that the third bonding wire does not cross paths with either the first bonding wire or the second bonding wire.

2. A semiconductor device (55) having structures for accurate bonding of bonding wires to leads in the semiconductor device, comprising:

a semiconductor die (70) having a plurality of bonding pads (67) located thereon;

a multi-tier package body (56) comprising:

a cavity (71) which accommodates the semiconductor die;

a first tier (60) surrounding the cavity;

a second tier (58) surrounding the cavity and located above the first tier;

first and second leads (59) formed on the second tier in successive lead positions, the first and second leads each having a predetermined width, the predetermined width of the first lead being substantially equal to the predetermined width of the second lead;

a third lead (61) formed on the first tier, the third lead having a predetermined width which is substantially larger than the predetermined widths of the first and second leads and having a protrusion (64) formed on an end thereof which is nearest the cavity, each of the third lead and the protrusion being positioned such that a first imaginary line extending from the protrusion to a first bonding pad (67) on the semiconductor die lies completely between a second imaginary line extending from the first lead to a second bonding pad (67) and a third imaginary line extending from the second lead to a third bonding (67) pad.

3. A semiconductor device comprising:

a semiconductor die (70) having a plurality of bonding pads (67) located thereon;

a multi-tier package body (56) comprising:

a cavity (71) which accommodates the semiconductor die;

at least one tier (60) surrounding the cavity and having a plurality of leads, each of said leads being electrically coupled by bonding wire to a predetermined bonding pad on the semiconductor die; and

at least one of said plurality of leads comprising a first area located proximate the cavity and a second area separated from the cavity by the first area, the second area having a greater area than the first area and the first area being arranged to receive the bonding wire for accurate bonding of the bonding wire to the leads.

*FIG.1*
-PRIOR ART-

*FIG.2*
-PRIOR ART-

*FIG.3*

*FIG.4*

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 513 355   (J.A.SCHROEDER ET AL.)<br>* column 5, line 42 - column 6, line 64; figures 2A, 2B, 3A, 3B * | 1-3 | H 01 L 23/498 |
| | – – – – – | | |

TECHNICAL FIELDS
SEARCHED (Int. Cl.5)

H 01 L

The present search report has been drawn up for all claims

| Place of search | Date of completion of search | Examiner |
|---|---|---|
| Berlin | 10 December 91 | LE MINH I |